# EUROPEAN PATENT APPLICATION

(11) **EP 4 372 129 A1**
(43) Date of publication of application: **22.05.2024**
(21) Application number: 23208705.6
(22) Date of filing: 09.11.2023
(51) Int. Cl.: C30B 25/14, C23C 16/455, C30B 25/16

(54) **EPITAXIAL GROWTH APPARATUS AND GAS SUPPLY CONTROL MODULE USED THEREFOR**

(30) Priority: 17.11.2022 KR 20220154126
(71) Applicant: PJP Tech Inc., Yongin-si, Gyeonggi-do 17096 (KR)
(72) Inventor: Choi, Bum Ho, Goyang-si, Gyeonggi-do 10324 (KR); Park, Kyung Shin, Suwon-si, Gyeonggi-do 16505 (KR); Kwon, Hyun Ho, Hwaseong-si, Gyeonggi-do 18477 (KR); Kim, Dong Hyoun, Incheon 21321 (KR); Lim, Suk Ho, Incheon 22657 (KR); Jeong, Jong Wook, Yongin-si, Gyeonggi-do 17081 (KR); Lee, Seung Soo, Suwon-si, Gyeonggi-do 16699 (KR)
(74) Representative: von Bülow & Tamada

(57) **Abstract**

Provided are an epitaxial growth apparatus and a gas supply control module used therefor, the epitaxial growth apparatus including: a reaction chamber; a susceptor positioned in the reaction chamber and configured to seat a wafer thereon; and a gas supply control module configured to control a flow of a gas flowing into the reaction chamber, wherein the gas supply control module includes an injector including a center port corresponding to a central region of the wafer, a pair of edge ports corresponding to both edge regions of the wafer, and a pair of middle ports respectively disposed between the center port and the pair of edge ports, and a flow distribution unit configured to independently distribute the gas flow input from a source module to the ports.

## Description

### BACKGROUND

### Field

The present disclosure relates to an epitaxial growth apparatus including a gas supply control module.

### Description of the Related Art

In general, epitaxial growth indicates stacking a new layer by using a single crystal growth method while maintaining a lattice direction with respect to a seed wafer. The epitaxial growth may require a growth apparatus allowing a gas to act on the wafer.

A gas supply system of the epitaxial growth apparatus may include an injector, a baffle, an insert, and a liner in an order in which the gas is injected from a gas tank into a chamber.

An important consideration in gas supply is providing uniform gas distribution in the chamber. Through the uniform gas distribution, an epitaxial layer may have a uniform thickness layer on a large-area substrate (i.e., a substrate having a size of 6 inches or more). It is preferable that the epitaxial layer achieves a uniformity of 1% or less. It is preferable that an epitaxial growth speed is 10 µm or more per minute.

However, in a conventional gas supply system, the uniform gas distribution may not be provided to the center and edge of the substrate. As a result, a grown epitaxial layer may have a thickness with a poor uniformity of 5% or more.

### SUMMARY

An object of the present disclosure is to provide an epitaxial growth apparatus which may provide uniform gas distribution in an entire region of a substrate to grow a uniform epitaxial layer on the large-area substrate at a high speed.

According to an embodiment of the present disclosure, an epitaxial growth apparatus includes: a reaction chamber; a susceptor positioned in the reaction chamber and configured to seat a wafer thereon; and a gas supply control module configured to control a flow of a gas flowing into the reaction chamber, wherein the gas supply control module includes an injector including a center port corresponding to a central region of the wafer, a pair of edge ports corresponding to both edge regions of the wafer, and a pair of middle ports respectively disposed between the center port and the pair of edge ports, a flow distribution unit configured to independently distribute the gas to the ports by including a single inflow line receiving the gas from a source module, five branch lines branched off from the single inflow line and respectively connected to the ports, and a mass flow controller connected to each of the ports, and a baffle including through holes through which the gas input through the ports passes, the through holes including a first through hole corresponding to the center port, a second through hole corresponding to the middle port, and a third through hole corresponding to the edge port, and the first to third through holes having shapes different from one another.

The flow distribution unit may distribute the gas for the gas flow in the pair of edge ports and the pair of middle ports to respectively be symmetric to each other based on the center port.

An input end of the first through hole may have a cross-sectional area smaller than an input end of the second through hole, and an output end of the first through hole may have a cross-sectional area larger than an output end of the second through hole.

An input end of the third through hole may have a cross-sectional area smaller than an input end of the second through hole, and an output end of the third through hole may have a cross-sectional area smaller than an output end of the second through hole.

The first through hole may have a cross-sectional area having the same size from its input end to its output end.

Each of the second through hole and the third through hole may have a cross-sectional area that gets smaller from its input end to its output end.

According to another embodiment of the present disclosure, provided is a gas supply control module used for an epitaxial growth apparatus, in which the module controls a flow of a gas input to a reaction chamber of the epitaxial growth apparatus, the module including: an injector including a center port corresponding to a central region of a wafer disposed in the reaction chamber, a pair of edge ports corresponding to both edge regions of the wafer, and a pair of middle ports respectively disposed between the center port and the pair of edge ports; a flow distribution unit configured to independently distribute the gas to the ports by including a single inflow line receiving the gas from a source module providing the gas, five branch lines branched off from the single inflow line and respectively connected to the ports, and a mass flow controller connected to each of the ports; and a baffle including through holes through which the gas input through the ports passes, the through holes including a first through hole corresponding to the center port, a second through hole corresponding to the middle port, and a third through hole corresponding to the edge port, and the first to third through holes having shapes different from one another.

An input end of the first through hole may have a cross-sectional area smaller than an input end of the second through hole, and an output end of the first through hole may have a cross-sectional area larger than an output end of the second through hole.

An input end of the third through hole may have a cross-sectional area smaller than an input end of the second through hole, and an output end of the third through hole may have a cross-sectional area smaller than an output end of the second through hole.

According to still another embodiment of the present disclosure, an epitaxial growth apparatus includes: a reaction chamber; a susceptor positioned in the reaction chamber and configured to seat a wafer thereon; and a gas supply control module configured to control a flow of a gas flowing into the reaction chamber, wherein the gas supply control module includes an injector including a center port corresponding to a central region of the wafer, a pair of edge ports corresponding to both edge regions of the wafer, and a pair of middle ports respectively disposed between the center port and the pair of edge ports, and a flow distribution unit configured to independently distribute the gas flow input from a source module to the ports.

The flow distribution unit may include a mass flow controller connected to each of the ports, and distributes the gas for the gas flow in the pair of edge ports and the pair of middle ports to respectively be symmetric to each other based on the center port.

The gas supply control module may further include a baffle including through holes through which the gas input through the ports passes, the through holes including a first through hole corresponding to the center port, a second through hole corresponding to the middle port, and a third through hole corresponding to the edge port, and the first to third through holes having shapes different from one another.

### BRIEF DESCRIPTION OF THE DRAWINGS

FIG. 1 is a conceptual diagram of an epitaxial growth apparatus according to an embodiment of the present disclosure.
FIG. 2 is a perspective view showing a partial configuration of the epitaxial growth apparatus of FIG. 1.
FIG. 3 is a horizontal cross-sectional view showing a configuration related to an injector of FIG. 2.
FIG. 4 is a front view showing the baffle and injector of FIG. 2.
FIGS. 5A to 5C are cross-sectional views respectively showing shapes of the first to third through holes of FIG. 4.
FIG. 6 is an image view showing a uniform gas flow achieved by the epitaxial growth apparatus of FIG. 1.

### DETAILED DESCRIPTION

Hereinafter, an epitaxial growth apparatus and a gas supply control module used therefor according to embodiments of the present disclosure are described in detail with reference to the accompanying drawings. Throughout the present disclosure, components that are the same as or similar to each other are denoted by reference numerals that are the same as or similar to each other, and a description thereof is replaced by the first description, even in a different embodiment.

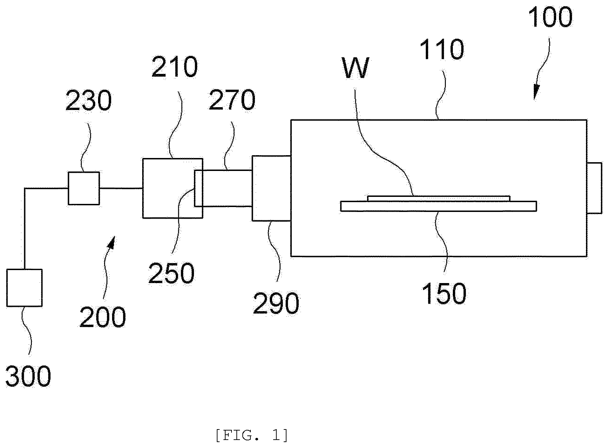

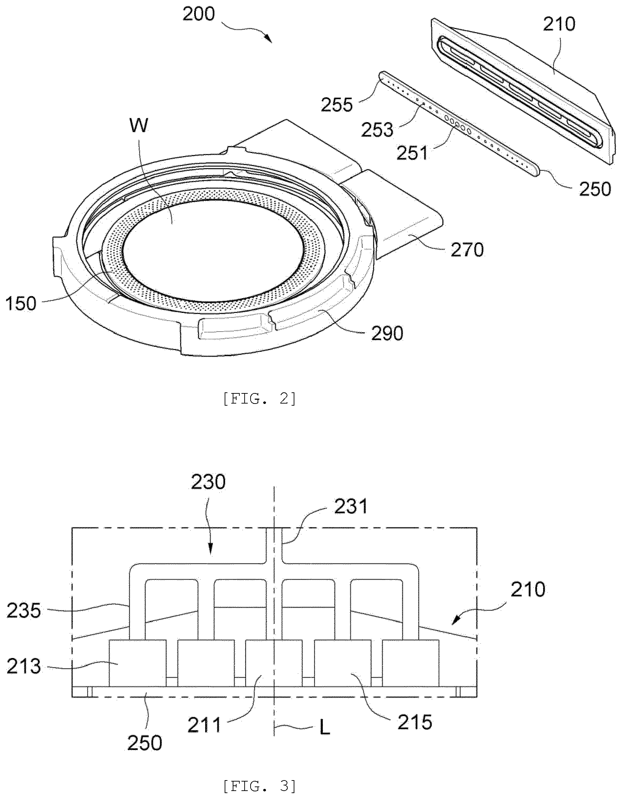

FIG. 1 is a conceptual diagram of an epitaxial growth apparatus according to an embodiment of the present disclosure; and FIG. 2 is a perspective view showing a partial configuration of the epitaxial growth apparatus of FIG. 1.

Referring to these drawings, an epitaxial growth apparatus 100 may include a reaction chamber 110, a susceptor 150, a gas supply control module 200, and a source module 300.

The reaction chamber 110 may have a reaction space where an epitaxial reaction occurs. The reaction space is simply indicated as a square box in the drawing. However, in detail, the reaction space may be provided by stacking a lower housing (not shown) and an upper housing (not shown) . Each of the upper housing and the lower housing may be made of a transparent material such as quartz glass. A gas may be supplied to a left side of the reaction space through the gas supply control module 200, and discharged to the right side of the reaction space.

The susceptor 150 may be positioned in the reaction space, and may be an object seating a wafer W thereon. The susceptor 150 may have a flat disk shape. The susceptor 150 may be made of carbon graphite or carbon graphite coated with silicon carbide. The wafer W may have a size of 6 inches or 8 inches or more, and thus be classified as having a large area.

The gas supply control module 200 may provide the gas into the reaction chamber 110 and control a gas flow. The gas supply control module 200 may include an injector 210, a flow distribution unit 230, a baffle 250, an insert 270, and a liner 290.

The injector 210 may discharge the gas input from the source module 300 toward the reaction chamber 110. The injector 210 may discharge a different gas flow based on a region of the wafer W seated on the susceptor 150. A specific configuration thereof is described with reference to FIG. 3.

The flow distribution unit 230 may distribute the gas flow input to the injector 210 for each region of the injector 210. The gas flow may be different for each region. This configuration is also described in detail with reference to FIG. 3.

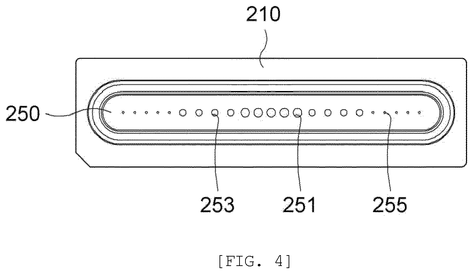

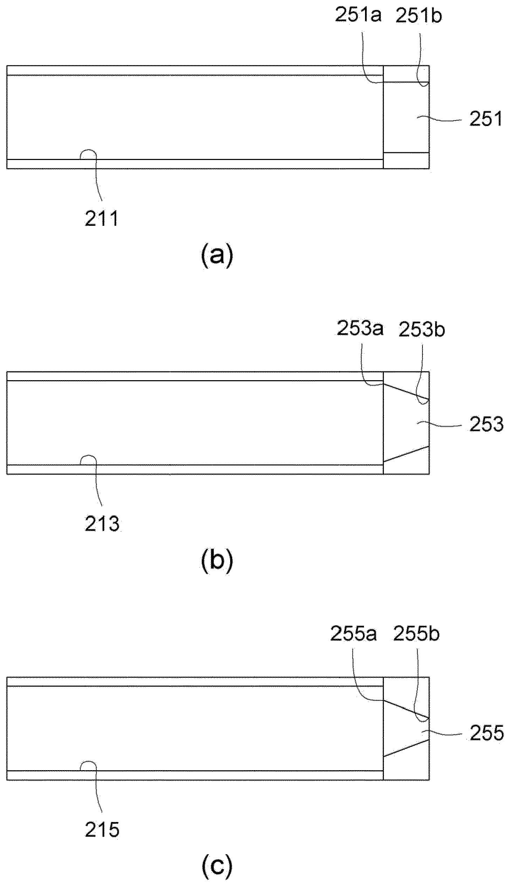

The baffle 250 may include through holes 251, 253, and 255 through which the gas input through the injector 210 passes. Shapes of the through holes 251, 253, and 255 may be different for each region of the injector 210. This configuration is described in more detail with reference to FIGS. 4 and 5.

The insert 270 may be positioned between the baffle 250 and the liner 290, and guide the gas passed through the baffle 250 to the liner 290. The insert 270 may also have a plurality of zones through which the gas passes.

The liner 290 may surround the susceptor 150, and guide the gas to flow into the wafer W. To this end, the liner 290 may have a generally ring shape. The liner 290 may have a part positioned on one side and discharging the gas toward the wafer W, and a part positioned on the other side and discharging the gas away from the wafer W.

The source module 300 may be a gas tank storing the gas to be supplied to the reaction chamber 110, or an intermediate distributor connected thereto.

Hereinafter, the injector 210 and the flow distribution unit 230 are described with reference to FIG. 3. FIG. 3 is a horizontal cross-sectional view showing a configuration related to the injector of FIG. 2.

Referring to this drawing further, the injector 210 may be a region through which the gas flows, and may include a center port 211, an edge port 213, and a middle port 215.

The center port 211 may be positioned to correspond to a central region of the wafer W. The pair of edge ports 213 may be positioned to correspond to both edge regions of the wafer W. The middle port 215 may be disposed between the center port 211 and the edge port 213. The pair of middle ports 215 may also be positioned on both of left and right sides of the center port 211. Left and right portions of the center port 211, the pair of edge ports 213, and the pair of middle ports 215 may respectively be symmetric to each other based on an imaginary line L passing through a center of the center port 211. The ports 211, 213, and 215 may have the same volume as one another. In detail, the ports 211, 213, and 215 may have the same width, depth, and height as one another.

The flow distribution unit 230 may have an inflow line 231 and a branch line 235. The inflow line 231 may be a line connected to the source module 300 to receive the gas. On the other hand, the branch line 235 may be branched off from one (or single) inflow line 231 and connected to each of the ports 211, 213, and 215. Therefore, five branch lines 235 may be provided.

The flow distribution unit 230 may have a mass flow controller (not shown) connected to each of the ports 211, 213, and 215. Five mass flow controllers may be provided, and installed in the respective branch lines 235. Each mass flow controller may be set to independently distribute the gas flow input to each of the ports 211, 213, and 215. For example, the gas flow input to the center port 211 may be set to the lowest and the gas flow input to the pair of edge ports 213 may be set to the highest. The gas flow input to the pair of middle ports 215 may be set to their intermediate level. The flow distribution unit 230 may also distribute the gas for the gas flow input to the pair of edge ports 213 or the pair of middle ports 215 to be symmetric to each other based on the center port 211.

Next, the description describes the baffle 250, which passes the gas flowing by divided into the five regions through the injector 210 toward the reaction chamber 110, with reference to FIGS. 4 and 5. FIG. 4 is a front view showing the baffle and injector of FIG. 2; and FIGS. 5A to 5C are cross-sectional views respectively showing shapes of the first to third through holes of FIG. 4.

Referring to these drawings, the gas input to the baffle 250 through the ports 211, 213, and 215 may respectively pass through the through holes 251, 253, and 255.

The through holes 251, 253, and 255 may include the first through hole 251, the second through hole 253, and the third through hole 255.

The first through hole 251 may be positioned to correspond to the center port 211. The second through hole 253 may be positioned to correspond to the middle port 215. The third through hole 255 may be positioned to correspond to the edge port 213.

The first through hole 251 to the third through hole 255 may have shapes different from one another. In detail, the first through hole 251 may have a cylindrical cross section having the same cross section from an input end 251a to an output end 251b. On the other hand, each of the second through hole 253 and the third through hole 255 may have a cone-shaped cross section. Each of the second through hole 253 and the third through hole 255 may have a cross section that gets smaller from the injector 210 to the insert 270.

When comparing the first through hole 251 with the second through hole 253, the input end 251a of the first through hole 251 may have a cross-sectional area smaller than an input end 253a of the second through hole 253. On the other hand, the output end 251b of the first through hole 251 may have a cross-sectional area larger than an output end 253b of the second through hole 253. This configuration may allow a speed of the gas passing through the second through hole 253 to be higher than a speed of the gas passing through the first through hole 251.

An input end 255a of the third through hole 255 may have a cross-sectional area smaller than or equal to the input end 253a of the second through hole 253. However, an output end 255b may have a cross-sectional area smaller than the output end 253b of the second through hole 253. This configuration may allow a speed of the gas passing through the third through hole 255 to be higher than the speed of the gas passing through the second through hole 253.

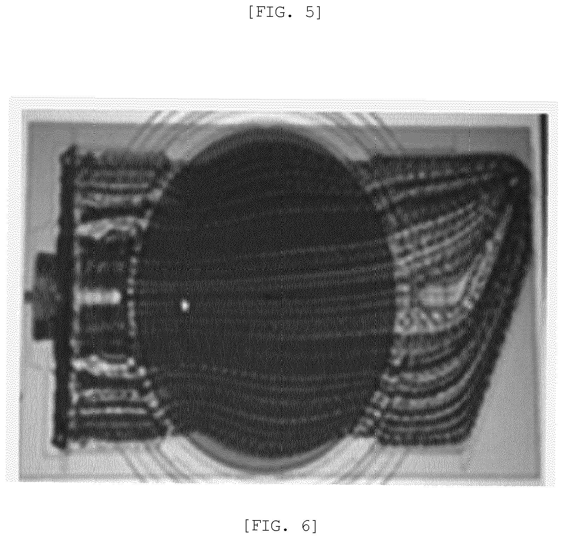

FIG. 6 shows the gas flow in the reaction chamber 110 by the configuration described above. FIG. 6 is an image view showing a uniform gas flow achieved by the epitaxial growth apparatus of FIG. 1.

Referring to this drawing further, it may be seen from a computer simulation that the gas flow to the wafer W is uniform throughout an entire region of the wafer W. In detail, the gas flow may be uniform in the central region of the wafer W, the edge region of the wafer W, and a region of the wafer W between these two regions.

This effect may be achieved by dividing ports 211, 213, and 215 of the injector 210 into five to correspond to the wafer W and differently injecting the gas thereinto, controlling the passing gas flows to be different for the ports 211, 213, and 215 by using the baffle 250, or the like when supplying the gas to the large-area wafer W. In addition, the gas flow may be concentrated on a surface of the wafer W to maximize concentration of the gas acting on the wafer W.

The gas flow distribution described above may solve problems that the gas has a slightly reduced flow as well as a reduced speed from the central region to edge region of the wafer W. The gas flow distribution may be especially important for the uniform gas distribution in a substrate of 8 inches or more.

In addition, the speed of the gas may be maintained at 100 to 250 cm/sec based on the shape of the through hole 251, 253, or 255. In this way, it is possible to achieve the uniform gas flow on the large-area wafer W.

According to the epitaxial growth apparatus and the gas supply control module used therefor according to the present disclosure configured as described above, the gas supply control module supplying the gas to the wafer seated on the susceptor in the reaction chamber may independently distribute the gas flow to each port through the injector including the center port, the pair of edge ports, and the pair of the middle ports, respectively disposed on its left and right sides to provide the uniform gas distribution in the entire region of the large-area substrate, thereby allowing the epitaxial layer to grow uniformly at a rapid speed.

The epitaxial growth apparatus and the gas supply control module used therefor as described above are not limited to the configurations and operation methods of the embodiments described above. The embodiments described above may be variously modified by selective combinations of all or some of the respective embodiments.

## Claims

1. An epitaxial growth apparatus comprising:
a reaction chamber;
a susceptor positioned in the reaction chamber and configured to seat a wafer thereon; and
a gas supply control module configured to control a flow of a gas flowing into the reaction chamber,
wherein the gas supply control module includes
an injector including a center port corresponding to a central region of the wafer, a pair of edge ports corresponding to both edge regions of the wafer, and a pair of middle ports respectively disposed between the center port and the pair of edge ports,
a flow distribution unit configured to independently distribute the gas to the ports by including a single inflow line receiving the gas from a source module, five branch lines branched off from the single inflow line and respectively connected to the ports, and a mass flow controller connected to each of the ports, and
a baffle including through holes through which the gas input through the ports passes,
the through holes including a first through hole corresponding to the center port, a second through hole corresponding to the middle port, and a third through hole corresponding to the edge port, and
the first to third through holes having shapes different from one another.

2. The apparatus of claim 1, wherein the flow distribution unit distributes the gas for the gas flow in the pair of edge ports and the pair of middle ports to respectively be symmetric to each other based on the center port.

3. The apparatus of claim 1, wherein an input end of the first through hole has a cross-sectional area smaller than an input end of the second through hole, and
an output end of the first through hole has a cross-sectional area larger than an output end of the second through hole.

4. The apparatus of claim 1, wherein an input end of the third through hole has a cross-sectional area smaller than an input end of the second through hole, and
an output end of the third through hole has a cross-sectional area smaller than an output end of the second through hole.

5. The apparatus of claim 1, wherein the first through hole has a cross-sectional area having the same size from its input end to its output end.

6. The apparatus of claim 1, wherein each of the second through hole and the third through hole has a cross-sectional area that gets smaller from its input end to its output end.

7. A gas supply control module used for an epitaxial growth apparatus, in which the module controls a flow of a gas input to a reaction chamber of the epitaxial growth apparatus, the module comprising:
an injector including a center port corresponding to a central region of a wafer disposed in the reaction chamber, a pair of edge ports corresponding to both edge regions of the wafer, and a pair of middle ports respectively disposed between the center port and the pair of edge ports;
a flow distribution unit configured to independently distribute the gas to the ports by including a single inflow line receiving the gas from a source module providing the gas, five branch lines branched off from the single inflow line and respectively connected to the ports, and a mass flow controller connected to each of the ports; and
a baffle including through holes through which the gas input through the ports passes,
the through holes including a first through hole corresponding to the center port, a second through hole corresponding to the middle port, and a third through hole corresponding to the edge port, and
the first to third through holes having shapes different from one another.

8. The module of claim 7, wherein an input end of the first through hole has a cross-sectional area smaller than an input end of the second through hole, and
an output end of the first through hole has a cross-sectional area larger than an output end of the second through hole.

9. The module of claim 7, wherein an input end of the third through hole has a cross-sectional area smaller than an input end of the second through hole, and
an output end of the third through hole has a cross-sectional area smaller than an output end of the second through hole.

10. An epitaxial growth apparatus comprising:
a reaction chamber;
a susceptor positioned in the reaction chamber and configured to seat a wafer thereon; and
a gas supply control module configured to control a flow of a gas flowing into the reaction chamber,
wherein the gas supply control module includes
an injector including a center port corresponding to a central region of the wafer, a pair of edge ports corresponding to both edge regions of the wafer, and a pair of middle ports respectively disposed between the center port and the pair of edge ports, and
a flow distribution unit configured to independently distribute the gas flow input from a source module to the ports.

11. The apparatus of claim 10, wherein the flow distribution unit includes a mass flow controller connected to each of the ports, and distributes the gas for the gas flow in the pair of edge ports and the pair of middle ports to respectively be symmetric to each other based on the center port.

12. The apparatus of claim 10, wherein the gas supply control module further includes a baffle including through holes through which the gas input through the ports passes,
the through holes including a first through hole corresponding to the center port, a second through hole corresponding to the middle port, and a third through hole corresponding to the edge port, and
the first to third through holes having shapes different from one another.
